(19) Europäisches Patentamt
European Patent Office
Office européen des brevets

(11) **EP 0 792 021 B1**

(12) **EUROPÄISCHE PATENTSCHRIFT**

(45) Veröffentlichungstag und Bekanntmachung des Hinweises auf die Patenterteilung:
**23.07.2003 Patentblatt 2003/30**

(51) Int Cl.$^7$: **H03K 19/018**, H03K 19/086

(21) Anmeldenummer: **97102007.8**

(22) Anmeldetag: **07.02.1997**

(54) **Treiberschaltung**

Driving circuit

Circuit d'attaque

(84) Benannte Vertragsstaaten:
**DE FR GB**

(30) Priorität: **13.02.1996 DE 19605248**

(43) Veröffentlichungstag der Anmeldung:
**27.08.1997 Patentblatt 1997/35**

(73) Patentinhaber: **Infineon Technologies AG**
**81669 München (DE)**

(72) Erfinder: **Wilhelm, Wilhelm, Dr.**
**81477 München (DE)**

(74) Vertreter: **Reinhard - Skuhra - Weise & Partner**
**Postfach 44 01 51**
**80750 München (DE)**

(56) Entgegenhaltungen:
**EP-A- 0 421 016          EP-A- 0 453 191**
**DE-A- 4 336 798          US-A- 4 894 562**

**Beschreibung**

Die Erfindung betrifft eine Treiberschaltung.

Insbesondere bei Logikschaltungen in Bipolartechnik werden in der Regel zum Treiben von Leitungen oder kapazitiven Lasten Emitterfolger verwendet. Bei der Schaltflanke, bei der der Emitterfolgertransistor durchgeschaltet wird, ist der Emitterfolger gut geeignet, die Leitung oder kapazitive Last umzuladen. Dagegen ist er bei der Flanke, bei der der Emitterfolgertransistor gesperrt wird, nur dann ausreichend schnell, wenn der Ruhestrom des Emitterfolgers groß genug gewählt wird. Tatsächlich braucht man diesen Strom aber nur während des Entladevorgangs der Lastkapazität oder der Leitungsimpedanz. Während der übrigen Zeit könnte er ohne Nachteil jedoch auch gleich Null sein. Dies würde zu einer erheblichen Einsparung an Versorgungsleistung führen.

Es sind im wesentlichen zwei Realisierungsmöglichkeiten bekannt, die diesen Gedanken aufgreifen. George R. Watson, "Advances in Biplar VLSI", Proceedings of the IEEE, Band 78, Nr. 11, November 1990 schlägt vor, durch eine Differenzierschaltung den Ruhestrom des Emitterfolgers während der den Emitterfolgertransistor sperrenden Flanke einzuschalten. Die Einschaltzeit sollte dabei proportional zur Größe der Last sein. Dadurch ist jedoch eine Anpassung an die jeweilige Last notwendig. Demzufolge ist diese Schaltungsart für Zellen-Designs bei kundenspezifischen integrierten Schaltungen weniger geeignet. Darüber hinaus wird zur Differenzierung ein Kondensator benötigt, der bei integrierter Schaltungstechnik nur mit verhältnismäßig hohem Flächenaufwand realisiert werden kann.

Eine andere Realisierungsmöglichkeit sieht vor, ähnlich der CMOS-Technik zwei Schalter zu verwenden. Das Problem dabei ist, daß der Querstrom im Ruhezustand unabhängig von Temperatur und Versorgungsspannung auf einem niedrigen Wert gehalten werden muß. Ein gewisser Ruhestrom ist dennoch erforderlich, da sonst die Schaltgeschwindigkeit erheblich reduziert würde. Dem amerikanischen Patent 5,381,057 folgend wird dieses Problem dadurch gelöst, daß der Schalter den Strom aus dem Ladungsreservoir eines Kondensators entnimmt und die Ruheströme danach einstellt. Nachteilig dabei ist, daß die Kapazität des Kondensators entsprechend der Schalthäufigkeit und der Zahl der Treiber zu bemessen ist und daher in der Regel ein verhältnismäßig großer Kondensator erforderlich ist. Ein großer Kondensator ist jedoch nicht oder nur schwer integrierbar.

Aufgabe der Erfindung ist es, eine integrierbare Treiberschaltung mit geringem Ruhestrom und hoher Schaltgeschwindigkeit bei beiden Schaltflanken anzugeben.

Die Aufgabe wird durch eine Treiberschaltung gemäß Patentanspruch 1 gelöst. Ausgestaltungen und Weiterbildungen des Erfindungsgedankens sind Gegenstand von Unteransprüchen.

Bei der erfindungsgemäßen Treiberschaltung wird vorteilhafterweise der Querstrom derart reguliert, daß sowohl temperaturbedingte Schwankungen als auch Versorgungsspannungsänderungen berücksichtigt und ausgeregelt werden.

Eine erfindungsgemäße Treiberschaltung zum Treiben einer zwischen einem Ausgangsanschluß und ein Bezugspotential geschalteten Last umfaßt insbesondere einen ersten Transistor, dessen Kollektor an ein erstes Versorgungspotential angeschlossen ist und dessen Emitter mit dem Ausgangsanschluß verbunden ist, sowie einen zweiten Transistor, dessen Kollektor mit dem Ausgangsanschluß verbunden ist und dessen Emitter an das Bezugspotential angeschlossen ist. Des weiteren ist ein emittergekoppeltes Transistorpaar vorgesehen, an dessen Basen ein symmetrisches Steuersignal angelegt ist, dessen einer Kollektor über einen ersten Widerstand mit dem ersten Versorgungspotential und dessen anderer Kollektor über einen zweiten Widerstand mit dem Ausgangsanschluß gekoppelt ist. Schließlich wird das Transistorpaar durch eine steuerbare Stromquelle gespeist, wobei die Steuerung der Stromquelle durch eine entsprechende Einrichtung proportional zu der zwischen erstem Versorgungspotential und Bezugspotential auftretenden Spannung erfolgt.

Bei einer Ausgestaltung der Erfindung umfaßt die gesteuerte Stromquelle einen dritten Transistor, dessen Kollektor mit den gekoppelten Emittern des Transistorpaares verbunden ist und dessen Emitter über einen dritten Widerstand mit einem zweiten Versorgungspotential gekoppelt ist. Die Steuereinrichtung weist dabei einen Verstärker auf, an dessen Eingang unter Zwischenschaltung eines Dämpfungsgliedes die Versorgungsspannung angelegt ist.

Dabei haben bevorzugt erster und zweiter Widerstand untereinander den gleichen und gegenüber dem dritten Widerstand den doppelten Wert. Das Dämpfungsglied ist dabei derart ausgebildet, daß die Versorgungsspannung halbiert wird.

Bevorzugt besteht dabei das Dämpfungsglied aus einem zwei Widerstände gleichen Wertes aufweisenden Spannungsteiler.

Bei einer anderen Weiterbildung der Erfindung weist die Verstärkerschaltung einen vierten Transistor auf, dessen Basis mit dem Ausgang des Dämpfungsglieds und dessen Kollektor mit dem ersten Versorgungspotential verbunden ist, sowie einen fünften Transistor, dessen Basis mit dem Bezugspotential, dessen Emitter unter Zwischenschaltung eines vierten Widerstandes mit einem zweiten Versorgungspotential und dessen Kollektor mit der steuerbaren Stromquelle sowie unter Zwischenschaltung eines fünften Widerstandes mit dem Emitter des vierten Transistors verbunden ist.

Bevorzugt werden den Basen des Transistorpaares Emitterfolger vorgeschaltet, von denen einer eingangsseitig mit dem Ausgang des Dämpfungsglieds verbunden ist und von denen der andere mit einem unsymmetrischen Eingangssignal angesteuert wird.

Der andere Emitterfolger weist bei einer anderen Ausgestaltung zwei ausgangsseitig einander parallel geschaltete Transistoren auf, von denen der eine mit dem einen unsymmetrischen Eingangssignal und der andere mit einem weiteren unsymmetrischen Eingangssignal angesteuert wird. Damit wird eine logische Verknüpfung beider unsymmetrischer Eingangssignale erzielt, wobei das Ausgangssignal aus der NOR-Verknüpfung der beiden unsymmetrischen Eingangssignale hervorgeht.

Schließlich sind bei einer Ausgestaltung der Erfindung erster und zweiter Transistor identisch.

Die Erfindung wird nachfolgend anhand der in den beiden Figuren der Zeichnung dargestellten Ausführungsbeispiele näher erläutert. Es zeigt:

Figur 1    eine erste allgemeine Ausführungsform einer erfindungsgemäßen Treiberschaltung und

Figur 2    eine Erweiterung der Treiberschaltung nach Figur 1.

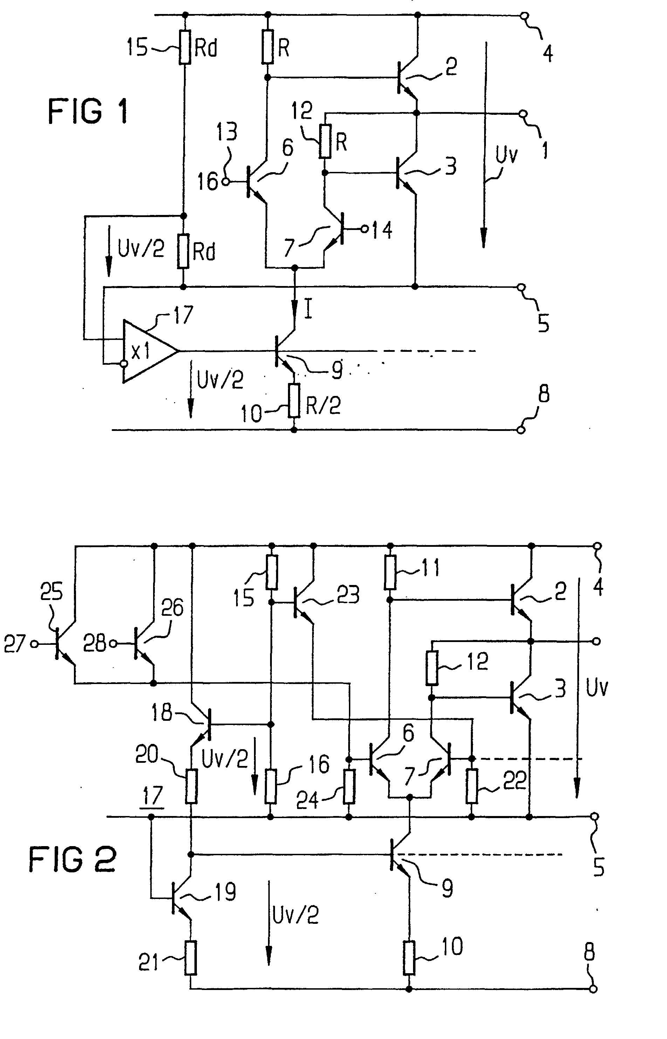

Bei dem Ausführungsbeispiel gemäß Figur 1 ist ein Ausgangsanschluß 1, an dem eine nicht näher bezeichnete Last angeschlossen werden soll, mit dem Emitter eines npn-Transistors 2 sowie mit dem Kollektor eines npn-Transistors 3 verbunden. Der Kollektor des Transistors 2 ist dabei an ein positives Versorgungspotential 4 und der Emitter des Transistors 3 an ein Bezugspotential 5 angeschlossen. Zwischen dem Versorgungspotential 4 und dem Bezugspotential 5 tritt dabei eine Versorgungsspannung Uv auf.

Weiterhin ist ein Transistorpaar mit zwei npn-Transistoren 6 und 7 vorgesehen, deren Emitter miteinander und unter Zwischenschaltung einer Stromquelle mit einem negativen Versorgungspotential 8 gekoppelt sind. Die steuerbare Stromquelle wird dabei durch einen npn-Transistor 9 gebildet, dessen Kollektor mit den gekoppelten Emittern der Transistoren 6 und 7 verbunden ist und dessen Emitter über einen Widerstand 10 an das negative Versorgungspotential 8 angeschlossen ist.

Der Kollektor des Transistors 6 ist mit der Basis des Transistors 2 sowie über einen Widerstand 11 mit dem positiven Versorgungspotential 4 verbunden. Der Kollektor des Transistors 7 ist mit der Basis des Transistors 3 verschaltet, wobei zwischen Basis und Kollektor des Transistors 3 ein Widerstand 12 geschaltet ist. Die Basen der Transistoren 6 und 7 bilden dabei den invertierenden bzw. nichtinvertierenden Eingang 13, 14 der Treiberschaltung.

Zwischen das positive Versorgungspotential 4 und das Bezugspotential 5 ist ein als Dämpfungsglied wirkender Spannungsteiler geschaltet, der aus zwei in Reihe geschalteten, jeweils den Wert Rd aufweisenden Widerständen 15 und 16 besteht. Durch die gleichgroßen Widerstände 15 und 16 wird die Versorgungsspannung Uv halbiert, so daß einem Verstärker 17, der eine Verstärkung von 1 aufweist, die halbe Versorgungsspannung Uv/2 zugeführt wird. Die halbe Versorgungsspannung Uv/2 wird über dem Widerstand 16 abgegriffen. Der Ausgang des Verstärkers 17, an dem ebenfalls die halbe Versorgungsspannung Uv/2 anliegt, steuert die Basis des Transistors 9. Darüber hinaus kann der Verstärker 17 die Transistoren weiterer, in der Zeichnung nicht dargestellter Stromquellen steuern, die zu weiteren ebenfalls nicht gezeigten Treiberschaltungen gehören.

Die Ausführungsform nach Figur 2 ist gegenüber der Ausführungsform nach Figur 1 erweitert, wobei gleiche Elemente mit gleichen Bezugszeichen versehen sind. Der Verstärker 17 aus Figur 1 wird dabei durch zwei npn-Transistoren 18 und 19 sowie zwei Widerständen 20 und 21 gebildet. Der Transistor 18 ist kollektorseitig an das positive Versorgungspotential 4 und basisseitig an den Abgriff des durch die Widerstände 15 und 16 gebildeten Spannungsteilers angeschlossen. Der Emitter des Transistors 18 ist über den Widerstand 20 mit dem Kollektor des Transistors 19 gekoppelt, dessen Basis an das Bezugspotential 5 und dessen Emitter unter Zwischenschaltung des Widerstandes 21 an das negative Versorgungspotential 8 angeschlossen ist. Der Kollektor des Transistors 19 bildet den Ausgang des Verstärkers 17 und ist daher mit der Basis des Transistors 9 sowie gegebenenfalls mit den Basen weiterer Stromquellentransistoren verbunden.

Darüber hinaus sind den Basen der Transistoren 6 und 7 Emitterfolger vorgeschaltet. Die Basis des Transistors 7 ist dazu zum einen über einen Widerstand 22 mit dem Bezugspotential 5 gekoppelt und zum anderen mit dem Emitter eines Transistors 23 verbunden, dessen Kollektor an das positive Versorgungspotential 4 angeschlossen ist und dessen Basis mit der Basis des Transistors 18 verschaltet ist. Die Basis des Transistors 6 ist zum einen über einen Widerstand 24 an das Bezugspotential 5 angeschlossen und zum anderen mit den Emittern zweier npn-Transistoren 25 und 26 verbunden, an deren Kollektoren das positive Versorgungspotential 4 angelegt ist. Die Basen der Transistoren 25 und 26 werden durch unsymmetrische Eingangssignale 27 bzw. 28 angesteuert. Die Signale 27 und 28 werden dabei miteinander ODER-verknüpft und dieses Signal durch die Treiberstufe selbst invertiert, so daß bezüglich des Ausgangsanschlusses 1 eine NOR-Verknüpfung realisiert wird. Die Transistoren 2, 3 und 9 sind ebenso wie bei dem Ausführungsbeispiel nach Figur 1 dabei bevorzugt identisch ausgeführt.

Die Transistoren 2 und 3 bilden zwei Schalter, die je nach Stellung der durch die Transistoren 6 und 7 gebildeten Stromschaltstufe wechselseitig ein- und abgeschaltet werden. Der Kollektorstrom I des Transistors 9 muß dabei so groß sein, daß ein über Temperatur- und Spannungsgang kontrollierter Querstrom durch die Transistoren 2 und 3 auftritt. Dies wird dadurch erreicht, daß die halbe Versorgungsspannung Uv/2 zur Erzeugung des Stromes I benutzt wird. Daraus ergibt sich:

$$I = (Uv/2-U_{BES})/(R/2) = (Uv-2U_{BES})/R,$$

wobei $U_{bes}$ die Basis-Emitter-Sättigungsspannung der Transistoren 9, 2 bzw. 3 und R den Wert der Widerstände 11 und 12 bzw. den doppelten Wert des Widerstandes 10. Aus obiger Gleichung folgt, daß

$$Uv = IR+2\ U_{BES}$$

ist. Demnach setzt sich die Versorgungsspannung über der Treiberstufe sowohl im H- als auch im L-Zustand aus zwei Basis-Emitter-Spannungen sowie einer Spannung, die gleich dem Produkt aus dem Strom I und den Widerstand R ist, zusammen. Damit kann aber der durch die Transistoren 2 und 3 fließende Querstrom nie größer sein als der Strom I.

Der Strom I wird dabei durch den Widerstandswert R und die Versorgungsspannung Uv bestimmt und kann demzufolge leicht eingestellt werden. Die Kontrolle des Querstroms ist auch bei anderen Versorgungsspannungen und Temperaturen garantiert. Weiterhin ist vorteilhaft, daß eine erfindungsgemäße Treiberschaltung auch bei niedrigen Versorgungsspannungen betriebsfähig ist.

**Patentansprüche**

1. Treiberschaltung zum Treiben einer zwischen einen Ausgangsanschluß (1) und ein Bezugspotential (5) geschalteten Last
mit einem ersten Transistor (2), dessen Kollektor an ein erstes Versorgungspotential (4) angeschlossen ist und dessen Emitter mit dem Ausgangsanschluß (1) verbunden ist,
mit einem zweiten Transistor (3), dessen Kollektor mit dem Ausgangsanschluß (1) verbunden ist und dessen Emitter an das Bezugspotential (5) angeschlossen ist,
mit einem emittergekoppelten Transistorpaar (6, 7), an dessen Basen ein symmetrisches Steuersignal (13, 14) angelegt ist, dessen einer Kollektor über einen ersten Widerstand (11) mit dem ersten Versorgungspotential (4) und dessen anderer Kollektor über einen zweiten Widerstand (12) mit dem Ausgangsanschluß (1) gekoppelt ist,
mit einer steuerbaren Stromquelle (9, 10) zur Speisung des Transistorpaares (6, 7) und
mit einer Steuereinrichtung (15, 16, 17) zum Steuern der Stromquelle (9, 10) proportional zu der zwischen erstem Versorgungspotential (4) und Bezugspotential (5) auftretenden Versorgungsspannung (Uv).

2. Treiberschaltung nach Anspruch 1,
**dadurch gekennzeichnet, daß** die gesteuerte Stromquelle (9, 10) einen dritten Transistor (9) aufweist, dessen Kollektor mit den gekoppelten Emittern des Transistorpaares (6, 7) verbunden ist und dessen Emitter über einen dritten Widerstand (10) mit einem zweiten Versorgungspotential (8) gekoppelt ist, und
daß die Steuereinrichtung (15, 16, 17) einen Differenzverstärker (17) aufweist, an dessen Eingang unter Zwischenschaltung eines Dämpfungsglieds (15, 16) die Versorgungsspannung (Uv) angelegt ist.

3. Treiberschaltung nach Anspruch 1 oder 2,
**dadurch gekennzeichnet, daß** erster und zweiter Widerstand (11, 12) den gleichen Wert R haben, daß der dritte Widerstand (10) den halben Wert (R/2) von erstem bzw. zweitem Widerstand (11, 12) hat, und daß das Dämpfungsglied (15, 16) die Versorgungsspannung (Uv) halbiert.

4. Treiberschaltung nach Anspruch 3,
**dadurch gekennzeichnet, daß** das Dämpfungsglied (15, 16) ein aus zwei Widerständen (15, 16) mit gleichem Wert (Rd) bestehender Spannungsteiler ist.

5. Treiberschaltung nach einem der Ansprüche 2 bis 4,
**dadurch gekennzeichnet, daß** die Verstärkerschaltung (17)
einen vierten Transistor (18), dessen Basis mit dem Ausgang des Dämpfungsglieds (15, 16) und dessen Kollektor mit dem ersten Versorgungspotential (4) verbunden ist, und
einen fünften Transistor (19), dessen Basis mit dem Bezugspotential (5), dessen Emitter unter Zwischenschaltung eines vierten Widerstandes (21) mit einem zweiten Versorgungspotential (8) und dessen Kollektor mit der steuerbaren Stromquelle (9, 10) sowie unter Zwischenschaltung eines fünften Widerstandes (20) mit dem Emitter des vierten Transistors (18) verbunden ist, aufweist.

6. Treiberschaltung nach einem der Ansprüche 2 bis 5,
**dadurch gekennzeichnet, daß** den Basen des Transistorpaares (6, 7) Emitterfolger (22, 23, 24, 25) vorgeschaltet sind, von denen der eine Emitterfolger (22, 23) eingangsseitig mit dem Ausgang des Dämpfungsglieds (15, 16) verbunden ist und von denen der andere Emitterfolger (24, 25) mit einem unsymmetrischen Eingangssignal (27) angesteuert wird.

7. Treiberschaltung nach Anspruch 6,
**dadurch gekennzeichnet, daß** der andere Emitterfolger (24, 25) einen durch das unsymmetrische Eingangssignal (27) gesteuerten Transistor (25) aufweist, dem ein durch ein weiteres unsymmetrisches Eingangssignal (28) gesteuerter, weiterer Transistor (26) ausgangsmäßig parallel geschaltet ist.

8. Treiberschaltung nach einem der Ansprüche 1 bis 7,
   **dadurch gekennzeichnet, daß** erster und zweiter Transistor (2, 3) einander gleichartig sind.

9. Treiberschaltung nach einem der Ansprüche 2 bis 8,
   **dadurch gekennzeichnet, daß** der dritte Transistor (9) zu erstem und/oder zweitem Transistor (2, 3) gleichartig ist.

## Claims

1. Driver circuit for driving a load connected between an output connection (1) and a reference-earth potential (5),
   having a first transistor (2), whose collector is connected to a first supply potential (4) and whose emitter is connected to the output connection (1),
   having a second transistor (3), whose collector is connected to the output connection (1) and whose emitter is connected to the reference-earth potential (5),
   having an emitter-coupled transistor pair (6, 7) whose bases have a symmetrical control signal (13, 14) applied to them, whose one collector is coupled to the first supply potential (4) via a first resistor (11) and whose other collector is coupled to the output connection (1) via a second resistor (12),
   having a controllable current source (9, 10) for feeding the transistor pair (6, 7), and
   having a control device (15, 16, 17) for controlling the current source (9, 10) in proportion to the supply voltage (Uv) appearing between the first supply potential (4) and reference-earth potential (5).

2. Driver circuit according to Claim 1,
   **characterized in that** the controlled current source (9, 10) has a third transistor (9), whose collector is connected to the coupled emitters of the transistor pair (6, 7) and whose emitter is coupled to a second supply potential (8) via a third resistor (10), and **in that** the control device (15, 16, 17) has a differential amplifier (17) whose input has the supply voltage (Uv) applied to it via an attenuator (15, 16).

3. Driver circuit according to Claim 1 or 2,
   **characterized in that** the first and second resistors (11, 12) have the same value R, **in that** the third resistor (10) has half the value (R/2) of the first or second resistor (11, 12), and **in that** the attenuator (15, 16) halves the supply voltage (Uv).

4. Driver circuit according to Claim 3,
   **characterized in that** the attenuator (15, 16) is a voltage divider comprising two resistors (15, 16) having the same value (Rd).

5. Driver circuit according to one of Claims 2 to 4,
   **characterized in that** the amplifier circuit (17) has a fourth transistor (18), whose base is connected to the output of the attenuator (15, 16) and whose collector is connected to the first supply potential (4), and
   a fifth transistor (19), whose base is connected to the reference-earth potential (5), whose emitter is connected to a second supply potential (8) via a fourth resistor (21) and whose collector is connected to the controllable current source (9, 10) and, via a fifth resistor (20), to the emitter of the fourth transistor (18).

6. Driver circuit according to one of Claims 2 to 5,
   **characterized in that** the bases of the transistor pair (6, 7) are preceded by emitter followers (22, 23, 24, 25), among which the input side of one emitter follower (22, 23) is connected to the output of the attenuator (15, 16) and among which the other emitter follower (24, 25) is actuated using an asymmetrical input signal (27).

7. Driver circuit according to Claim 6,
   **characterized in that** the other emitter follower (24, 25) has a transistor (25) which is controlled by the asymmetrical input signal (27) and whose output has a further transistor (26), controlled by a further asymmetrical input signal (28), connected in parallel with it.

8. Driver circuit according to one of Claims 1 to 7,
   **characterized in that** the first and second transistors (2, 3) are identical to one another.

9. Driver circuit according to one of Claims 2 to 8,
   **characterized in that** the third transistor (9) is identical to the first and/or second transistor (2, 3).

## Revendications

1. Circuit d'excitation pour l'excitation d'une charge branchée entre un raccordement de sortie (1) et un potentiel de référence (5)
   avec un premier transistor (2), dont le collecteur est relié à un premier potentiel d'alimentation (4) et dont l'émetteur est relié au raccordement de sortie (1),
   avec un deuxième transistor (3) dont le collecteur est relié au raccordement de sortie (1) et dont l'émetteur est relié au potentiel de référence (5),

avec une paire de transistors (6, 7) couplés par l'émetteur, aux bases desquelles un signal de contrôle symétrique (13, 14) est appliqué, dont un des collecteurs est relié au premier potentiel d'alimentation (4) par l'intermédiaire d'une première résistance (11) et dont l'autre collecteur est relié au raccordement de sortie (1) par l'intermédiaire d'une deuxième résistance (12),

avec une source de courant contrôlable (9, 10) pour l'alimentation de la paire de transistors (6, 7) et

avec un dispositif de contrôle (15, 16, 17) pour contrôler la source de courant (9, 10) proportionnellement à la tension d'alimentation (Uv) régnant entre le premier potentiel d'alimentation (4) et le potentiel de référence (5).

2. Circuit d'excitation selon la revendication 1, **caractérisé en ce que** la source de courant contrôlée (9, 10) comporte un troisième transistor (9) dont le collecteur est relié aux émetteurs couplés de la paire de transistors (6, 7) et dont l'émetteur est relié à un deuxième potentiel d'alimentation (8) par l'intermédiaire d'une troisième résistance (10), et

**en ce que** le dispositif de contrôle (15, 16, 17) comporte un amplificateur différentiel (17) à l'entrée duquel la tension d'alimentation (Uv) est appliquée par l'intermédiaire d'un élément d'amortissement (15, 16).

3. Circuit d'excitation selon la revendication 1 ou 2, **caractérisé en ce que** la première et la deuxième résistance (11, 12) ont la même valeur R, **en ce que** la troisième résistance (10) a la moitié (R/2) de la valeur de la première et de la deuxième résistance (11, 12), et **en ce que** l'élément d'amortissement (15, 16) divise la tension d'alimentation (Uv) par deux.

4. Circuit d'excitation selon la revendication 3, **caractérisé en ce que** l'élément d'amortissement (15, 16) est un diviseur de tension constitué de deux résistances (15, 16) ayant la même valeur (Rd).

5. Circuit d'excitation selon l'une des revendications 2 à 4, **caractérisé en ce que** le circuit d'amplification (17) comporte

un quatrième transistor (18) dont la base est reliée à la sortie de l'élément d'amortissement (15, 16) et dont le collecteur est relié au premier potentiel d'alimentation (4), et

un cinquième transistor (19) dont la base est reliée au potentiel de référence (5), dont l'émetteur est relié à un deuxième potentiel d'alimentation (8) par l'intermédiaire d'une quatrième résistance (21) et dont le collecteur est relié à la source de courant contrôlée (9, 10) ainsi qu'à l'émetteur du quatrième transistor (18) par l'intermédiaire d'une cinquième résistance (20).

6. Circuit d'excitation selon l'une des revendications 2 à 5, **caractérisé en ce que** des émetteurs-suiveurs (22, 23, 24, 25) sont branchés en amont des bases de la paire de transistors (6, 7), l'un des émetteurs-suiveurs (22, 23) étant relié, du côté de l'entrée, à la sortie de l'élément d'amortissement (15, 16) et l'autre émetteur-suiveur (24, 25) est contrôlé à l'aide d'un signal d'entrée asymétrique (27).

7. Circuit d'excitation selon la revendication 6, **caractérisé en ce que** l'autre émetteur-suiveur (24, 25) comporte un transistor (25), contrôlé par le signal d'entrée asymétrique (27), avec lequel est branché, en parallèle du côté de la sortie, un autre transistor (26) contrôlé par un autre signal d'entrée asymétrique (28).

8. Circuit d'excitation selon l'une des revendications 1 à 7, **caractérisé en ce que** le premier et le deuxième transistor (2, 3) sont du même type.

9. Circuit d'excitation selon l'une des revendications 2 à 8, **caractérisé en ce que** le troisième transistor (9) est du même type que le premier et/ou le deuxième transistor (2, 3).

FIG 1

FIG 2